# EUROPEAN PATENT SPECIFICATION

(11) **EP 2 980 857 B1**
(45) Date of publication and mention of the grant of the patent: **27.02.2019**
(21) Application number: 14772970.1
(22) Date of filing: 20.03.2014
(51) Int. Cl.: H01B 1/16, H01B 1/22, H01L 31/0224, C09D 5/24

(54) **CONDUCTIVE PASTE FOR SOLAR CELL ELEMENT SURFACE ELECTRODES AND METHOD FOR MANUFACTURING SOLAR CELL ELEMENT**
LEITFÄHIGE PASTE FÜR SOLARZELLENELEMENT-OBERFLÄCHENELEKTRODEN UND VERFAHREN ZUR HERSTELLUNG EINES SOLARZELLENELEMENTS
PÂTE CONDUCTRICE POUR ÉLECTRODE DE SURFACE POUR ÉLÉMENT DE PILE SOLAIRE, ET PROCÉDÉ DE FABRICATION D'ÉLÉMENT DE PILE SOLAIRE

(30) Priority: 29.03.2013 JP 2013071237
(43) Date of publication of application: 03.02.2016
(73) Proprietor: Shoei Chemical Inc., Tokyo 163-0443 (JP)
(72) Inventor: AKIMOTO, Yuji, Tosu-shi Saga 841-0048 (JP); KANASAKU, Tadashi, Tosu-shi Saga 841-0048 (JP); NISHIMURA, Kousuke, Tosu-shi Saga 841-0048 (JP); MIURA, Yoshio, Kyoto-shi Kyoto 612-8501 (JP)
(74) Representative: SSM Sandmair
(86) International application number: PCT/JP2014/057786
(87) International publication number: WO 2014/156964

(56) References cited:
- EP-A2- 2 472 526
- WO-A1-2013/036510
- JP-A- S5 636 172
- JP-A- 2009 124 148
- JP-A- 2012 084 585

## Description

### Technical Field

The present invention relates to a conductive paste for a front surface electrode of a solar cell element and to a method for manufacturing a solar cell element.

### Background Art

A solar cell element is generally provided with a silicon-based, for example, p-type, semiconductor substrate, an n-type diffusion layer, an antireflective film, a back surface electrode, and a front surface electrode. A conductive paste made by mixing a conductive powder comprising silver as a main component with glass frit, an organic vehicle, and so forth is used to form the front surface electrode. This conductive paste is formed, for example, by screen printing or stencil printing, into an electrode pattern on the antireflective film that has been formed on one main surface side (the light-receiving surface side) of the semiconductor substrate, and is then fired to form the front surface electrodes.

During this firing, the antireflective film is ordinarily dissolved and removed by the action of the glass frit present in the conductive paste. This results in the generation of electrical contact between the front surface electrode and the diffusion layer. This process is generally referred to as fire-through.

In order for fire-through to proceed well, a glass with an excellent solubility for the antireflective film is desirably used as the glass frit in the conductive paste. Lead-containing glass has heretofore frequently been used as the glass frit for the following reasons: its softening point can be easily adjusted; it also exhibits an excellent adherence to the semiconductor substrate; and it enables fire-through to be carried out relatively well (refer, for example, to Patent Document 1). However, in investigations carried out by the present inventors, a high tensile strength was obtained when a lead-containing glass frit was used, but the problem of a high contact resistance also occurred.

There have also been efforts to use a tellurium-containing glass frit as the glass frit (refer, for example, to Patent Document 2). According to investigations by the present inventors, the use of a tellurium-containing glass frit does yield a low contact resistance, but a satisfactory tensile strength may not be obtained depending on the firing temperature and the condition of the surface of the substrate used therewith. There have therefore also been attempts to use glass frit that contains both lead and tellurium (refer, for example, to Patent Document 3).

### Citation List

### Patent Literature

Patent Document 1: Japanese Patent Publication No. 2001-93326 A
Patent Document 2: Japanese Patent Publication No. 2012-84585 A
Patent Document 3: WO 2011/140197 A1

### Summary of Invention

### Technical Problem

However, the glass frit that contains both lead and tellurium has properties intermediate between those of lead-containing glass frit and tellurium-containing glass frit and both properties, i.e., the tensile strength and the contact resistance, are inadequate, and the inability for a low contact resistance to co-exist with a high tensile strength (adhesive strength) has been a problem here.

An object of the present invention is to provide a conductive paste that forms a front surface electrode of a solar cell element that has a low contact resistance and a high tensile strength. An additional object of the present invention is to provide a method for manufacturing a solar cell element.

### Solution to Problem

The conductive paste for a front surface electrode of a solar cell element according to an aspect of the present invention is a conductive paste for a solar cell element front surface electrode that is used to form a front surface electrode of a solar cell element that is provided with a semiconductor substrate, an antireflective film disposed in a first region on one main surface of the semiconductor substrate, and a front surface electrode disposed in a second region on the one main surface of the semiconductor substrate, characterized in that the conductive paste comprises a conductive powder, a mixed glass frit, and an organic vehicle in which the mixed glass frit contains, in the form of mixture, a tellurium-based glass frit containing tellurium, tungsten, and bismuth and a lead-bismuth-based glass frit that contains lead and bismuth and that does not contain more than 1,000 ppm tellurium; as further defined in claim 1.

The method according to another aspect of the present invention for manufacturing a solar cell element which comprises a silicon semiconductor substrate, an antireflective
film disposed in a first region on one main surface of the semiconductor substrate, and a front surface electrode disposed in a second region on the one main surface of the semiconductor substrate, the method comprising:
a first step of forming the antireflective film on the one main surface of the semiconductor substrate;
a second step of printing, on the antireflective film, a conductive paste comprising a conductive powder, a mixed glass frit, and an organic vehicle in which, the mixed glass frit contains, in the form of mixture, a tellurium-based glass frit containing tellurium, tungsten, and bismuth and a lead-bismuth-based glass frit that contains lead and bismuth and that does not contain tellurium;
and a third step of disposing the antireflective film in the first region of the semiconductor substrate and forming the front surface electrode in the second region of the semiconductor substrate, by firing the conductive paste and removing the antireflective film located under the conductive paste; as further defined in claim 5.

### Advantageous Effects of Invention

The present invention provides a solar cell element that has front surface electrodes that exhibit a low contact resistance and a high tensile strength and also provides a method for manufacturing this solar cell element. The conversion efficiency of the solar cell element is raised as a consequence.

### Brief Description of Drawings

FIG. 1 is a cross-sectional diagram that schematically shows an embodiment of a solar cell element having a front surface electrode formed using the conductive paste of the present invention; and
FIGS. 2(a) to 2(e) are cross-sectional diagrams that schematically show steps in manufacturing the solar cell element of the present invention.

### Description of Embodiments

Examples of embodiments of the conductive paste for front surface electrodes of a solar cell element according to the present invention and the method according to the present invention for manufacturing the solar cell element are described hereinbelow with reference to the drawings.

### [The conductive paste for solar cell element front surface electrodes]

The basic structure of a solar cell element in which the front surface electrodes are formed using the conductive paste of the present embodiment is described first.

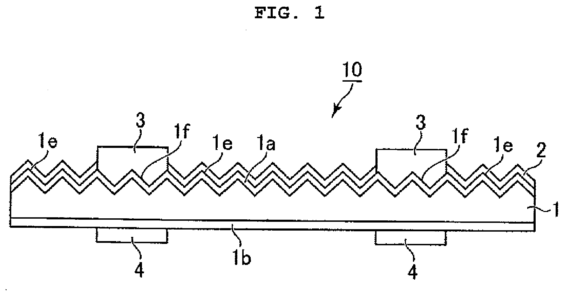

As shown in FIG. 1, a solar cell element 10 of the present embodiment is provided with a semiconductor substrate 1 that has a first semiconductor region having one type of conductivity and a second semiconductor region (an opposite conductivity type layer 1a) having the opposite type of conductivity from the first semiconductor region, and with an antireflective film 2 that is disposed in a first region 1e on a first surface (on the opposite conductivity type layer 1a in the present embodiment) that is a main surface on the side of the semiconductor substrate 1 where light enters.

The solar cell element 10 further has a first electrode 3 that is a front surface electrode disposed on a second region If on the first surface of the semiconductor substrate 1, and has a second electrode 4 that is a back surface electrode disposed on a second surface that is a main surface on the side opposite from the first surface of the semiconductor substrate 1.

A crystalline silicon substrate, for example, a monocrystalline silicon substrate or a multicrystalline silicon substrate, that has a predetermined dopant element (an impurity for controlling the type of conductivity) and that exhibits one type of conductivity (for example, p-type) is used as the semiconductor substrate 1. The thickness of the semiconductor substrate 1 is, for example, more preferably not more than 250 µm and even more preferably not more than 150 µm. In the present embodiment, a case where a crystalline silicon substrate exhibiting a conductivity type of p-type is used as the semiconductor substrate 1 is described by way of example. In order for the semiconductor substrate 1 made of a crystalline silicon substrate to exhibit the p-type, it is preferred that boron or gallium, for example, be used as the dopant element.

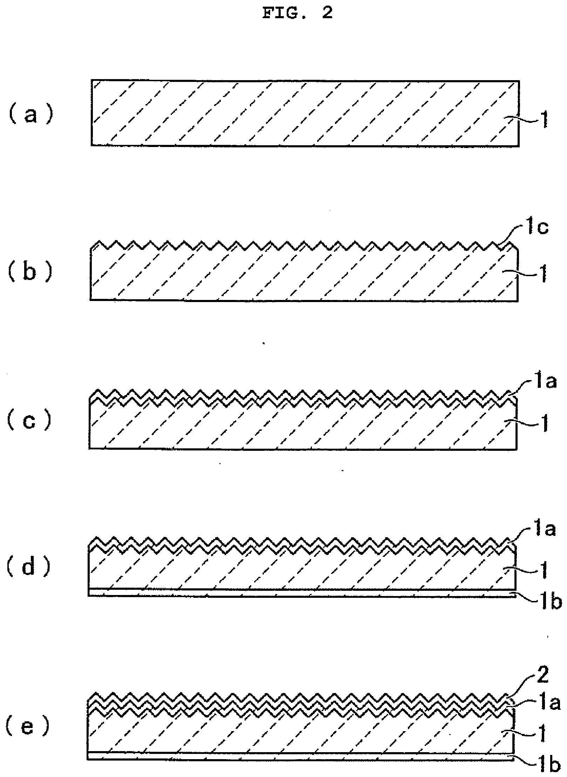

A large number of microscopic projections 1c, shown in FIG. 2, are formed on the first surface side of the semiconductor substrate 1. These microscopic projections 1c are disposed in order to cause multiple reflections of the light incident on the surface side of the semiconductor substrate 1 and reduce the reflection of the light from the surface. These microscopic projections 1c can be conical or pyramidal and their size can be changed by adjusting the gas concentration or etching time in reactive ion etching (RIE) method.

The opposite conductivity type layer 1a is a layer that exhibits conductivity opposite to that of the semiconductor substrate 1, and, for example, is formed in the surface layer of the first surface of the semiconductor substrate 1. When a silicon substrate that exhibits p-type conductivity is used as the semiconductor substrate 1, the opposite conductivity type layer 1a is formed so as to exhibit n-type conductivity. Such an opposite conductivity type layer 1a can be formed, for example, by the diffusion of an impurity such as phosphorus into the first surface of the silicon substrate.

The antireflective film 2 is a film that functions to reduce the reflectance of the light in the desired wavelength range and to increase the amount of photogenerated carriers and can increase the photocurrent density Jsc of the solar cell element 10. The antireflective film 2 can be, for example, an SiNₓ film, TiO₂ film, SiO₂ film, MgO film, ITO film, SnO₂ film, or ZnO film. The thickness thereof is selected as appropriate depending on the material so as to enable the realization of nonreflective conditions for the appropriate incident light.

As shown in FIG. 1, the solar cell element 10 has a p+ conductivity-type back surface field (BSF) region 1b formed in the surface layer part at the second surface side of the semiconductor substrate 1. The BSF region 1b functions to reduce the decline in photoelectric conversion efficiency caused by carrier recombination in the vicinity of the second surface of the semiconductor substrate 1, and forms an internal electric field at the second surface side of the semiconductor substrate 1.

The first electrode 3 has first bus bar electrodes and a plurality of linear finger electrodes that intersect with the first bus bar electrodes. The first bus bar electrodes have, for example, a width of approximately 1.3 to 2.5 mm. The finger electrodes are linear and have a width of approximately 50 to 200 µm and thus are narrower than the first bus bar electrodes.

The plurality of finger electrodes are disposed with a spacing of about 1.5 to 3 mm therebetween. The thickness of this first electrode 3 is approximately 10 to 40 µm. This first electrode 3 can be formed, as described below, by screen printing or the like a conductive paste into a desired shape on the antireflective film 2 and thereafter firing. The conductive paste used comprises a conductive powder containing silver as its main component, a mixed glass frit in which a tellurium-based glass frit is mixed with a lead-bismuth-based glass frit, and an organic vehicle.

The second electrode 4 may have the same electrode shape as the first electrode 3 and may be formed by the same material and method as the first electrode 3 described above. In addition, second bus bar electrodes comprising silver may be formed, and a collector electrode composed of aluminum may be formed over substantially the entire surface excluding the second bus bar electrodes on the second surface of the semiconductor substrate 1.

The texture structure and the conductive paste used for electrode formation are described in detail hereinbelow for the solar cell element of the present embodiment.

The texture structure will be described first.

The solar cell element 10 is provided, on the first surface side of the semiconductor substrate 1, with a texture structure that has projections 1c that have an average width of not more than 10 µm and an average height of not more than 10 µm. This texture structure can be formed, for example, by a wet etching method using an alkali solution, e.g., of NaOH, or an acid solution, e.g., of fluonitric acid, or by a dry etching method using, for example, reactive ion etching (RIE). When the average width or the average height of these projections 1c is larger than 10 µm, this extends the etching processing time, while there is no appreciable further reduction of the reflectance at the front surface of the semiconductor substrate 1.

The average width and the average height of the projections 1c are each preferably from at least 0.1 µm to not more than 1 µm. With this range, the reflectance at the surface of the semiconductor substrate 1 can be reduced and in addition these microscopic projections 1c can be formed uniformly over the entire surface of the first surface side of the semiconductor substrate 1 with accurate controllability.

The aspect ratio (height/width of the projection 1c) of these microscopic projections 1c is desirably 0.1 to 2 on average. When this aspect ratio is less than 0.1 on average, for example, the average reflectance of light with a wavelength of 500 to 1000 nm is about 25% and the surface of the semiconductor substrate 1 then has a large reflectance. When this aspect ratio exceeds 2 on average, the microscopic projections 1c are broken during the manufacturing process and a large leakage current then occurs when the solar cell element 10 is formed and excellent output characteristics will not be obtained.

The conductive paste for forming the first electrode 3, which is the front surface electrode, is described in detail in the following.

The first electrode 3 is formed using, as the glass frit for the conductive paste, a mixed glass frit that contains a tellurium-based glass frit containing tellurium, tungsten, and bismuth as essential components mixed with a lead-bismuth-based glass frit that contains lead and bismuth as essential components and that substantially does not contain tellurium. In this Description, the constituent components of each glass frit are present in the glass frit as the oxide unless specifically indicated otherwise. The indication that a particular component X is "substantially not contained" does not exclude an unavoidable content of component X and may encompass the case in which, for example, component X is contained at not more than 1,000 ppm. In addition, the conductive paste for forming the first electrode 3 comprises the previously described conductive powder, the mixed glass frit, suitable additives, and an organic vehicle. This conductive paste is a paste, paint, or ink composition having a rheology adapted to screen printing or another printing method.

The content of the mixed glass frit in the conductive paste is an amount that can ordinarily be blended in a conductive paste for solar cell electrode formation, and is 0.1 to 10 mass parts per 100 mass parts of the conductive powder. The predetermined adherence and electrode strength can be obtained when the blending amount of the mixed glass frit is at least 0.1 mass part per 100 mass parts of the conductive powder. When the blending amount of the mixed glass frit is not more than 10 mass parts per 100 mass parts of the conductive powder, this can reduce the occurrence of glass flotation on the electrode surface and can reduce the increase in the contact resistance caused by glass flowing into the interface between the electrode and the diffusion layer of the semiconductor substrate. While not a particular limitation, the tellurium-based glass frit and lead-bismuth-based glass frit blended in the conductive paste in the present embodiment desirably have an average particle size of 0.7 to 2.0 µm.

The conductive powder has silver as a main component, but is not otherwise particularly limited, and those shapes heretofore used, e.g., spherical, flake, dendritic, and so forth, may be used for the shape of the conductive powder. Besides a pure silver powder, for example, a silver-coated composite powder in which at least the surface is composed of a silver layer, alloys in which silver is a main component, and so forth, may also be used. The conductive powder, e.g., silver powder and so forth, preferably has an average particle size of 0.1 to 10 µm. A mixture of two or more conductive powders that differ in their, for example, average particle size, particle size distribution, shape, and so forth, may be used, and a mixture of a silver powder with a non-silver conductive powder may also be used. The "main component" indicated above refers to a component that is incorporated in excess of 50 mass% and preferably refers to a component that is incorporated at 70 mass% or more. Insofar as the function and effects of the present embodiment are not impaired, there are no particular limitations on the metal used to form a composite, alloy, or mixture with the silver powder, and this metal can be exemplified by aluminum, gold, palladium, copper, nickel, and so forth. However, the use of a pure silver powder is desirable from the standpoint of the conductivity.

There are no particular limitations on the organic vehicle, and the organic binders, solvents, and so forth ordinarily used as vehicles in silver pastes may be selected and incorporated as appropriate. Examples of organic binders include celluloses, acrylic resins, phenolic resins, alkyd resins, rosin esters and the like. Examples of solvents include organic solvents such as alcohols, ethers, esters, and hydrocarbons; water; and mixed solvents of these solvents. The blending amount of the organic vehicle is not particularly limited here and is a suitable amount capable of retaining the inorganic components, e.g., the conductive powder and mixed glass frit, in the paste and may be adjusted as appropriate in conformity to, for example, the application method; however, it is generally about 5 to 40 mass parts per 100 mass parts of the conductive powder.

With regard to other components, the plasticizers, viscosity modifiers, surfactants, oxidizing agents, metal oxides, organometal compounds, and so forth, that can ordinarily be added as additives may be blended as appropriate on an optional basis within a range in which the effects of the present embodiment are not impaired. Silver compounds such as silver carbonate, silver oxide, and silver acetate may also be blended, and, for example, copper oxide, zinc oxide, titanium oxide, and so forth may be added as appropriate in order to improve the firing temperature and solar cell properties.

At least any one of tin, tin(II) oxide (SnO), and tin(IV) oxide (SnO₂) is preferably added as an additive. The effect of reducing the contact resistance or increasing the tensile strength is obtained by doing this. The amount of addition for this additive is preferably 0.05 to 3 mass parts per 100 mass parts of the conductive powder.

The tellurium-based glass frit contains, as the oxide, 30 to 80 mol% of tellurium, 10 to 50 mol% of tungsten, and 5 to 25 mol% of bismuth, and contains, as the oxide, for example, at least 50 mol% and preferably 65 to 85 mol% for the sum of the tellurium, tungsten, and bismuth.

The tellurium in the tellurium-based glass frit, as a network-forming component, forms a glass network, and glass formation readily occurs when it is present in the range from 30 to 80 mol% as the oxide with respect to the overall tellurium-based glass frit, while the range from 40 to 70 mol% is preferred. This range is preferred in terms of improving the fire-through performance.

Tungsten contributes, for this tellurium-based glass frit in particular, to stabilization and to broadening the vitrification range. Glass formation readily occurs at 10 to 50 mol% of tungsten as the oxide, while a content in the range from 15 to 35 mol% is preferred. This range is preferred in terms of further improving the fire-through performance.

Bismuth contributes, for this tellurium-based glass frit in particular, to broadening the vitrification range and improving the chemical durability. When the bismuth is contained in an amount exceeding 25 mol% as the oxide, formation of a crystalline phase may readily occur and the stability of the glass may be impaired. The range from 5 to 25 mol% is preferred from the standpoint of lessening the problem of bleeding of the glass components.

The tellurium-based glass frit preferably contains silver. This makes it possible to lower the contact resistance even further. The silver content is preferably 3 to 40 mol% as the oxide with respect to the overall tellurium-based glass frit. An effect from the incorporation of the silver is not obtained at less than 3 mol%, while the silver component may readily precipitate in the glass at around or in excess of 40 mol%.

While not essential, the tellurium-based glass frit may additionally contain one or more of alkali metal elements such as lithium and sodium, an alkaline-earth metal element such as magnesium, calcium, strontium, and barium, and elements such as boron, aluminum, phosphorus, titanium, vanadium, zinc, germanium, zirconium, niobium, molybdenum, and lanthanum. The sum of the contents of these elements in the tellurium-based glass frit is preferably not more than 50 mol% as the oxides.

On the other hand, as the lead-bismuth-based glass frit, a glass frit containing lead and bismuth as essential components and additionally containing, e.g., zinc, silicon, boron, and so forth, may be used. According to the invention, the lead-bismuth-based glass frits contain, as the oxide, 30 to 70 mol% of lead, 10 to 40 mol% of bismuth, not more than 30 mol% of zinc (including 0 mol%), and 5 to 30 mol% of silicon, for example, wherein the sum as the oxides of the lead, bismuth, zinc, and silicon is at least 60 mol%
and is more preferably at least 80 mol%, or the lead-bismuth-based glass frit contains, as the oxide, 30 to 70 mol% of lead, 10 to 40 mol% of bismuth, not more than 30 mol% of zinc (including 0 mol%), and 1 to 25 mol% of boron, for example, wherein the sum as the oxides of the lead, bismuth, zinc, and boron is at least 60 mol% and more preferably at least 80 mol%.

As a network-forming component, lead forms a glass network in this lead-bismuth-based glass frit in particular. Glass formation readily occurs at 30 to 70 mol% of lead as the oxide, and a content in the range from 40 to 60 mol% is preferred. This range is preferred in terms of improving the fire-through performance.

Bismuth contributes, for this lead-bismuth-based glass frit in particular, to broadening the vitrification range and improving the chemical durability. The vitrification range is broadened when the bismuth is 10 to 40 mol% as the oxide, and a content in the 20 to 30 mol% range is preferred. Obtaining an improvement in the chemical durability is increasingly difficult at below 20 mol%, while there is a risk that the fire-through performance will be impaired at above 30 mol%.

Zinc is a preferred optional component for this lead-bismuth-based glass frit in particular, and as an intermediate oxide aids glass network formation. Glass formation readily occurs by incorporating zinc at an upper limit of 30 mol% as the oxide, and a zinc content in the range from 10 to 20 mol% is preferred. This range is preferred from the standpoint of stabilizing the glass.

For this lead bismuth-based glass frit in particular, silicon aids in glass network formation and facilitates softening point adjustment. Glass formation readily occurs at 5 to 30 mol% of silicon as the oxide, and a content in the range from 10 to 20 mol% is preferred. At above 20 mol%, there is a possibility that the softening point will be too high or that network formation by the lead as a network-forming component will be inhibited.

The boron aids, for this lead-bismuth-based glass frit in particular, in glass network formation. Glass formation readily occurs when boron is 1 to 25 mol% as the oxide, and a content in the range from 10 to 20 mol% is preferred. When 20 mol% is exceeded, the fire-through performance of the lead may be impaired or softening point adjustment becomes difficult.

While not essential, the lead-bismuth-based glass frit may additionally contain one or more of alkali metal elements such as lithium and sodium, alkaline-earth metal elements such as calcium, and barium, rare-earth elements such as cerium, terbium, thulium, and praseodymium, and elements such as aluminum, vanadium, zirconium, silver, lanthanum, and tungsten. The sum of the contents of these elements in the lead-bismuth-based glass frit is preferably not more than 50 mol% as the oxides.

The blending ratio between the tellurium-based glass frit and the lead-bismuth-based glass frit in the mixed glass frit is 4 : 6 to 8 : 2 as the mass ratio in order to form a front surface electrode by which a low contact resistance and a high tensile strength both are obtained. In addition, although the mixed glass frit has to contain at least the tellurium-based glass frit in mixture with the lead-bismuth-based glass frit, these glass frits are contained in total at more than 50 mass parts per 100 mass parts of the overall mixed glass frit, and the mixed glass frit may also further contain other glass frits. For example, a lead-tellurium-based glass frit containing lead and tellurium as its essential components may also be incorporated. A further reduction in the contact resistance can be obtained by this glass frit.

A preferred lead-tellurium-based glass frit can be exemplified by a glass frit that contains, as the oxide, 30 to 70 mol% of lead, 20 to 60 mol% of tellurium, and 5 to 10 mol% of tungsten, wherein the sum of the lead, tellurium, and tungsten is at least 60 mol% and is more preferably at least 80 mol%. However, in the lead-tellurium-based glass frit, the tungsten is not essential. The lead-tellurium-based glass frit may contain boron, molybdenum, niobium, magnesium, titanium, aluminum, etc.

As has been described in the preceding, a front surface electrode having both of a low contact resistance and a high tensile strength can be formed through the use of a conductive paste comprising a mixed glass frit that contains, in the form of a mixture, a tellurium-based glass frit and a lead-bismuth-based glass frit. This effect is certainly not obtained for the use for the glass frit of either the tellurium-based glass frit or the lead-bismuth-based glass frit alone, but is also not obtained for the use of a lead-tellurium-based glass frit alone.

The reason for this is unclear, but it is thought that excellent effects with regard to lowering the contact resistance and raising the tensile strength could be realized by mixing two glass frits that had substantially different properties, i.e., a tellurium-based glass frit having a low contact resistance and a lead-bismuth-based glass frit having a high tensile strength, but which still had a poor tendency to intermelt with each other.

Moreover, tellurium-based glasses and lead-bismuth-based glasses generally have different softening points, with tellurium-based glasses having lower softening points than lead-bismuth-based glasses. For example, the softening point of tellurium-based glasses is about 300 to 400°C, while the softening point of lead-bismuth-based glasses is about 360 to 440°C. It is thought that additional effects are obtained, in accordance with the following reasoning, due to the tellurium-based glass frit having a lower softening point than the lead-bismuth-based glass frit as indicated.

In the firing process, the tellurium-based glass frit, which has the lower softening point and has the effect of lowering the contact resistance, softens and spreads out first and coats the semiconductor substrate. After this, the lead-bismuth-based glass frit, which has the higher softening point and has an excellent reactivity with the antireflective film, softens and like a wedge breaks through the antireflective film at those locations where the tellurium-based glass does not cover the semiconductor substrate. It is thought that this interaction between the tellurium-based glass frit and the lead-bismuth-based glass frit brings about additional improvements with regard to the tensile strength and lowering the contact resistance.

Here, the difference between the softening point of the tellurium-based glass frit and the softening point of the lead-bismuth-based glass frit is preferably 10 to 100°C and more preferably 30 to 70°C. The expression of the functions described above is restrained when the difference between their softening points is less than 10°C. When the difference exceeds 100°C, the tellurium-based glass entirely covers the semiconductor substrate, making it difficult for the lead-bismuth-based glass to break through the antireflective film.

### [The manufacturing method]

A summary of the method for manufacturing a solar cell element of the present embodiment is described in the following.

The method of producing the semiconductor substrate 1 is described first. When the semiconductor substrate 1 is a monocrystalline silicon substrate, it may be formed, for example, by a pulling method or the like; when the semiconductor substrate 1 is a multicrystalline silicon substrate, it may be formed, for example, by a casting method or the like. Hereinafter, the example of the use of p-type multicrystalline silicon is described.

Initially, for example, an ingot of multicrystalline silicon is produced by a casting method. This ingot is subsequently sliced to a thickness of, for example, not more than 250 µm. Then, in order to remove the mechanically damaged layer of the sliced section or clean off the contaminated layer of the semiconductor substrate 1, the surface is desirably very lightly etched with, for example, an aqueous solution of NaOH or KOH or hydrofluoric acid or fluonitric acid (refer to FIG. 2(a)).

Next, as necessary a large number of microscopic projections 1c are formed on the first surface side of the semiconductor substrate 1. These microscopic projections 1c may be formed using an RIE method. An example of this is described in the following. First, the semiconductor substrate 1 is placed on the upper part of the RF electrode of the RIE apparatus, and then the inside of a chamber grounded by an earth is vacuum-drawn sufficiently using a vacuum pump. An etching gas containing a chlorine-based gas, a fluorine-based gas, and oxygen gas is then introduced into the chamber at a predetermined flow rate using a mass flow controller, and the reaction pressure is adjusted to about 5 to 15 Pa with a pressure regulator. Cl₂, HCl, and ClF₃ can be used for the chlorine-based gas, and CHF₃, F₂, NF₃, CF₄, C₂F₆, C₃F₈, ClF₃, and SF₆ can be used as the fluorine-based gas. Approximately 5 to 10 kW of RF power is subsequently applied to the RF electrode from the RF power source in order to excite and decompose the etching gas and produce a plasma state. The surface of the semiconductor substrate 1 is etched by the ions and radicals that are produced.

The constituent components of the surface are basically detached when the surface of the semiconductor substrate 1 is etched. However, a portion of these constituent components does not undergo detachment and remains on the surface of the semiconductor substrate 1 while a portion of the detached material re-adheres to the surface of the semiconductor substrate 1, and these form an etching residue. By intentionally allowing this etching residue, in which the main component is the etched material from the semiconductor substrate 1, to re-attach to the surface of the semiconductor substrate 1 and utilizing this as an etching mask, a roughening of the surface of the semiconductor substrate 1 that leads to formation of a concave-convex surface structure is then realized (refer to FIG. 2(b)).

Next, the n-type opposite conductivity type layer 1a is formed in the surface layer of the first surface of the semiconductor substrate 1. The opposite conductivity type layer 1a is formed by a coating thermal diffusion method for applying P₂O₅ in a paste form to the surface of the semiconductor substrate 1 and then thermally diffusing the same, a gas-phase thermal diffusion method for using POCl₃ (phosphorus oxychloride) in a gas form as a diffusion source, an ion implantation method for diffusing phosphorus ions directly to the surface, and the like. The opposite conductivity type layer 1a is formed to have a depth of approximately 0.2 to 2.0 µm and a sheet resistance of approximately 60 to 150 Ω/□ (see Fig. 2(c)).

Next, the BSF region 1b is formed on the second surface side of the semiconductor substrate 1, the BSF region 1b having a semiconductor impurity of one conductivity type diffused at high concentration. For instance, there can be used a method for forming the BSF region 1b at a temperature of about 800 to 1100°C by means of a thermal diffusion method using BBr₃ (boron tribromide) as a diffusion source, and a method for applying an Al (aluminum) paste comprising Al powder, an organic vehicle and the like by means of a printing method and thereafter thermally treating (firing) the Al paste at a temperature of approximately 600 to 850°C to diffuse Al in the semiconductor substrate 1. The method for printing and firing the Al paste can not only form a desired diffusion region only on a printed surface, but also eliminate the need to remove the n-type opposite conductivity type layer that is formed on the second surface side at the same time when the opposite conductivity type layer 1a is formed. Thus, it is only necessary to perform pn isolation only on the peripheries of the second surface side by using a laser or the like. Furthermore, the aluminum resulted from the firing process may be used as a collector electrode without being removed (see Fig. 2(d)).

Subsequently, the antireflective film 2 is formed on the first surface of the semiconductor substrate 1. The antireflective film 2 is formed by, for example, a PECVD (plasma enhanced chemical vapor deposition) method, a vapor deposition method, a sputtering method, or the like. For instance, when using the PECVD method to form the antireflective film 2 configured by an SiNₓ film, the antireflective film 2 is formed by diluting a mixed gas of SiH₄ (silane) and NH₃ (ammonia) with N₂ (nitrogen), with the temperature inside a reaction chamber at approximately 500°C, and then forming the mixed gas into a plasma with glow discharge decomposition and deposition (see Fig. 2(e)).

The first electrode 3 and the second electrode 4 are then formed as described in the following.

The first electrode 3 is fabricated, for example, using an Ag paste that contains an organic vehicle, the mixed glass frit, and a metal powder composed of, for example, Ag (silver). This Ag paste is coated on the antireflective film 2 on the first surface of the semiconductor substrate 1. Fire through is then performed by firing the Ag paste for about several tens of seconds to several tens of minutes at a peak temperature of 600 to 850°C. As a result of this, the antireflective film 2 positioned under the applied Ag paste is perforated and the first electrode 3 is formed in the second region 1f on the first surface of the semiconductor substrate 1 in which the antireflective film 2 is disposed in the first region 1e on the first surface of the semiconductor substrate 1 and the first electrode 3 is brought into electrical contact with the opposite conductivity type layer 1a. Screen printing methods and so forth can be used as the method for applying the Ag paste, and preferably, after the application of the Ag paste, the solvent is driven off at a predetermined temperature to dry the paste.

Subsequently, the second electrode 4 is prepared using, for example, an Ag paste that contains metal powder comprising Ag and the like, an organic vehicle, and a glass frit. In addition, the metal powder, organic vehicle, and glass frit used to form the second electrode 4 may be the same as or different from the materials used to form the first electrode 3. This Ag paste is applied in a predetermined shape on the second surface side of the semiconductor substrate 1. Screen printing and so forth may be used for the application method here. After application, drying is preferably performed by evaporating off the solvent at a predetermined temperature. The second electrode 4 is then formed on the second surface of the semiconductor substrate 1 by firing the semiconductor substrate 1 within a firing furnace for several tens of seconds to several tens of minutes at a peak temperature of 600 to 850°C.

The solar cell element 10 can be fabricated proceeding as described above.

### EXAMPLES

The present embodiment is described in the following by more specific examples, but the present embodiment is not limited thereto.

A silicon substrate of 200 µm-thick, 15.6 cm x 15.6 cm square multicrystalline silicon having a specific resistance of 1.5 Ω · cm was immersed in an NaOH solution and each surface was etched by 10 µm. Following this, etching was carried out for about 5 minutes with a reaction pressure of 7 Pa and an RF power of 5 kW for generating a plasma while introducing Cl₂ gas, O₂ gas, and CHF₃ gas in a proportion of 1 : 6 : 4 as the flow rate ratio into a chamber 17. This execution of RIE produced a texture structure through the formation on the surface of the silicon substrate of microscopic projections having an average width of 1 µm and an average height of 1 µm.

Then, P (phosphorus) was diffused so that the sheet resistance of the front surface part of the silicon substrate would become 80 Ω/□. Next, an Al paste was screen-printed onto a back surface of the silicon substrate, which was then fired at a temperature of 750°C. The sheet resistance of the back surface of the silicon substrate was 15 Ω/□. Subsequently, an SiNₓ film having a refractive index of 2.1 and a film thickness of 80 Å was formed on the front surface side of the silicon substrate by means of a plasma CVD method, to obtain an antireflective film.

On the other hand, tellurium-based glass frits (Table 1), lead-bismuth-based glass frits (Table 2), and lead-tellurium-based glass frits (Table 3) having the average particle sizes given in the indicated tables were obtained by preparing the starting materials so as to provide the oxide compositions for the respective glasses given in Tables 1 to 3, melting at 700 to 1000°C using an alumina crucible, obtaining the glasses by cooling in air or quenching, and pulverizing the glasses. The components in the glass compositions in Tables 1 to 3 are each given in mol% as the oxide, and the softening point (°C) of each glass frit is also reported in the same tables.

**Table 1**

| | Glass composition | | | | Softening point (°C) | Average particle size (*µ*m) |
|---|---|---|---|---|---|---|
| | Te | W | Bi | Ag | | |
| A1 | 42 | 18 | 11 | 29 | 320 | 1.0 |
| A2 | 42 | 18 | 11 | 29 | 320 | 1.9 |
| A3 | 43 | 21 | 7 | 29 | 350 | 0.94 |
| A4 | 50 | 25 | 8 | 17 | 410 | 1.1 |
| A5 | 60 | 25 | 15 | | 440 | 1.1 |
| A6 | 35 | 29 | 7 | 29 | 360 | 0.89 |
| A7 | 50 | 14 | 7 | 29 | 310 | 1.0 |

**Table 2**

| | Glass composition | | | | | | | Softening point (°C) | Average particle size (*µ*m) |
|---|---|---|---|---|---|---|---|---|---|
| | Pb | Bi | Zn | Si | B | Ti | Al | | |
| B1 | 40 | 20 | 20 | 20 | | | | 370 | 1.2 |
| B2 | 60 | 20 | 10 | 10 | | | | 370 | 1.2 |
| B3 | 30 | 30 | 20 | 20 | | | | 420 | 1.2 |
| B4 | 30 | 30 | 10 | 30 | | | | 460 | 1.3 |
| B5 | 30 | 30 | 20 | | 20 | | | 400 | 1.2 |
| B6 | 40 | 30 | 20 | | 10 | | | 370 | 1.2 |
| B7 | 60 | 20 | | 20 | | | | 380 | 1.1 |
| B8 | 50 | 20 | | 30 | | | | 410 | 1.3 |
| B9 | 57 | 19 | | 19 | | 5 | | 400 | 1.2 |
| B10 | 58 | 19 | | 19 | | | 4 | 380 | 1.2 |

**Table 3**

| | Glass composition | | | | | | | | | Softening point (°C) | Average particle (*µ*m) |
|---|---|---|---|---|---|---|---|---|---|---|---|
| | Pb | Te | W | B | Mo | Nb | Mg | Ti | Al | | |
| C1 | 50 | 45 | 5 | | | | | | | 330 | 0.81 |
| C2 | 55 | 35 | 10 | | | | | | | 230 | 0.71 |
| C3 | 70 | 20 | | 10 | | | | | | 320 | 0.92 |
| C4 | 40 | 50 | | | 10 | | | | | 300 | 0.78 |
| C5 | 35 | 60 | | | | 5 | | | | 500 | 0.83 |
| C6 | 40 | 55 | | | | | 5 | | | 320 | 0.81 |
| C7 | 33 | 52 | | 5 | | | | 10 | | 390 | 0.89 |
| C8 | 33 | 55 | | 2 | | | | 7 | 3 | 380 | 0.87 |

100 mass parts of a silver powder having an average particle diameter (D50) of 1.8 µm - calculated from a laser diffraction scattering particle size distribution measurement - and, at the mass parts given in Tables 4-1 and 4-2, the individual glass frits or glass frits mixed in the mass parts given in the same tables, were dispersed in an organic vehicle of 0.6 mass parts of ethyl cellulose and 2.4 mass parts of butyl carbitol to produce conductive pastes (samples 1 to 67). Samples 8 to 16 in Table 4-1 additionally contain tin (Sn), tin(II) oxide (SnO), or tin(IV) oxide (SnO₂) as an additive in the mixed glass frit. Samples marked with an asterisk (*) are samples outside the scope of the present invention.

**Table 4-1**

| Sample No. | Te-based glass frit | | Pb-Bi-based glass frit | | Pb-Te-based glass frit | | Additive | | Contact resistance (mΩcm²) | Tensile strength | Difference in softening point(°C)* |
|---|---|---|---|---|---|---|---|---|---|---|---|
| | Kind | Content (by mass part) | Kind | Content (by mass part) | Kind | Content (by mass part) | Kind | Content (by mass part) | | | |
| *1 | A1 | 1.9 | | | | | | | 25 | 1/6 | - |
| *2 | | | | | C1 | 2.1 | | | 53 | 2/6 | - |
| *3 | | | B2 | 2.3 | | | | | 733 | 6/6 | - |
| *4 | A1 | 1.0 | | | C1 | 1.4 | | | 27 | 0/6 | - |
| 5 | A1 | 1.3 | B1 | 0.7 | | | | | 57 | 5/6 | 50 |
| 6 | A1 | 1.0 | B2 | 0.6 | | | | | 38 | 5/6 | 50 |
| 7 | A1 | 1.3 | B2 | 0.4 | | | | | 27 | 3/6 | 50 |
| 8 | A1 | 1.3 | B2 | 0.4 | | | Sn | 0.075 | 24 | 3/6 | 50 |
| 9 | A1 | 1.3 | B2 | 0.4 | | | SnO | 0.075 | 12 | 3/6 | 50 |
| 10 | A1 | 1.3 | B2 | 0.4 | | | SnO₂ | 0.075 | 22 | 3/6 | 50 |
| 11 | A1 | 1.3 | B2 | 0.4 | | | Sn | 0.2 | 18 | 3/6 | 50 |
| 12 | A1 | 1.3 | B2 | 0.4 | | | SnO | 0.2 | 9 | 3/6 | 50 |
| 13 | A1 | 1.3 | B2 | 0.4 | | | SnO₂ | 0.2 | 15 | 4/6 | 50 |
| 14 | A1 | 1.3 | B2 | 0.4 | | | Sn | 2.5 | 26 | 5/6 | 50 |
| 15 | A1 | 1.3 | B2 | 0.4 | | | SnO | 2.5 | 24 | 5/6 | 50 |
| 16 | A1 | 1.3 | B2 | 0.4 | | | SnO₂ | 2.5 | 24 | 5/6 | 50 |
| 17 | A1 | 1.3 | B2 | 0.8 | | | | | 30 | 6/6 | 50 |
| 18 | A1 | 1.0 | B3 | 0.6 | | | | | 15 | 3/6 | 100 |
| 19 | A1 | 1.0 | B5 | 0.6 | | | | | 18 | 3/6 | 80 |
| 20 | A1 | 1.0 | B6 | 0.6 | | | | | 35 | 4/6 | 50 |
| 21 | A1 | 1.0 | B7 | 0.6 | | | | | 32 | 4/6 | 60 |
| 22 | A1 | 1.0 | B8 | 0.6 | | | | | 21 | 3/6 | 90 |
| 23 | A1 | 1.0 | B9 | 0.6 | | | | | 24 | 3/6 | 80 |
| 24 | A1 | 1.0 | B10 | 0.6 | | | | | 33 | 4/6 | 60 |
| 25 | A3 | 1.0 | B2 | 0.6 | | | | | 48 | 6/6 | 20 |
| 26 | A3 | 1.0 | B3 | 0.6 | | | | | 35 | 4/6 | 70 |
| 27 | A3 | 1.0 | B5 | 0.6 | | | | | 38 | 4/6 | 50 |
| 28 | A3 | 1.0 | B6 | 0.6 | | | | | 50 | 6/6 | 20 |
| 29 | A3 | 1.0 | B7 | 0.6 | | | | | 47 | 6/6 | 30 |
| 30 | A3 | 1.0 | B8 | 0.6 | | | | | 36 | 4/6 | 60 |
| 31 | A3 | 1.0 | B9 | 0.6 | | | | | 39 | 4/6 | 50 |
| 32 | A3 | 1.0 | B10 | 0.6 | | | | | 48 | 6/6 | 30 |
| 33 | A4 | 1.0 | B3 | 0.6 | | | | | 53 | 6/6 | 10 |
| 34 | A4 | 1.0 | B4 | 0.6 | | | | | 42 | 4/6 | 50 |

**Table 4-2**

| Sample No. | Te-based glass frit | | Pb-Bi-based glass frit | | Pb-Te-based glass frit | | Additive | | Contact resistance (mΩcm²) | Tensile strength | Difference in softening point(°C)* |
|---|---|---|---|---|---|---|---|---|---|---|---|
| | Kind | Content (by mass part) | Kind | Content (by mass part) | Kind | Content (by mass part) | Kind | Content (by mass part) | | | |
| 35 | A5 | 1.0 | B4 | 0.6 | | | | | 47 | 5/6 | 20 |
| 36 | A6 | 1.0 | B3 | 0.6 | | | | | 38 | 4/6 | 60 |
| 37 | A6 | 1.0 | B4 | 0.6 | | | | | 27 | 3/6 | 100 |
| 38 | A6 | 1.0 | B5 | 0.6 | | | | | 44 | 5/6 | 40 |
| 39 | A6 | 1.0 | B7 | 0.6 | | | | | 50 | 5/6 | 20 |
| 40 | A6 | 1.0 | B8 | 0.6 | | | | | 41 | 4/6 | 50 |
| 41 | A6 | 1.0 | B9 | 0.6 | | | | | 45 | 5/6 | 40 |
| 42 | A6 | 1.0 | B10 | 0.6 | | | | | 51 | 6/6 | 20 |
| 43 | A7 | 1.0 | B2 | 0.6 | | | | | 29 | 5/6 | 60 |
| 44 | A7 | 1.0 | B5 | 0.6 | | | | | 17 | 3/6 | 90 |
| 45 | A7 | 1.0 | B6 | 0.6 | | | | | 30 | 4/6 | 60 |
| 46 | A7 | 1.0 | B7 | 0.6 | | | | | 33 | 4/6 | 70 |
| 47 | A7 | 1.0 | B8 | 0.6 | | | | | 12 | 3/6 | 100 |
| 48 | A7 | 1.0 | B9 | 0.6 | | | | | 18 | 3/6 | 90 |
| 49 | A7 | 1.0 | B10 | 0.6 | | | | | 35 | 3/6 | 70 |
| 50 | A1 | 1.0 | B2 | 0.5 | C1 | 0.3 | | | 16 | 4/6 | 50 |
| 51 | A2 | 1.0 | B2 | 0.5 | C1 | 0.3 | | | 14 | 6/6 | 50 |
| 52 | A1 | 1.0 | B2 | 0.8 | C1 | 0.3 | | | 34 | 6/6 | 50 |
| 53 | A1 | 1.3 | B2 | 0.6 | C1 | 0.3 | | | 21 | 5/6 | 50 |
| 54 | A2 | 1.6 | B2 | 0.5 | C1 | 0.3 | | | 16 | 5/6 | 50 |
| 55 | A1 | 1.6 | B2 | 0.8 | C1 | 0.3 | | | 11 | 6/6 | 50 |
| 56 | A2 | 1.6 | B2 | 0.8 | C1 | 0.3 | | | 19 | 4/6 | 50 |
| 57 | A1 | 1.6 | B2 | 1.0 | C1 | 0.3 | | | 26 | 6/6 | 50 |
| 58 | A1 | 2.2 | B2 | 0.8 | C1 | 0.3 | | | 23 | 5/6 | 50 |
| 59 | A1 | 1.0 | B2 | 0.5 | C2 | 0.3 | | | 14 | 6/6 | 50 |
| 60 | A1 | 1.6 | B2 | 0.5 | C2 | 0.3 | | | 13 | 6/6 | 50 |
| 61 | A1 | 1.6 | B2 | 0.8 | C2 | 0.3 | | | 27 | 4/6 | 50 |
| 62 | A1 | 1.6 | B2 | 0.5 | C3 | 0.3 | | | 15 | 5/6 | 50 |
| 63 | A1 | 1.6 | B2 | 0.5 | C4 | 0.3 | | | 23 | 6/6 | 50 |
| 64 | A1 | 1.6 | B2 | 0.5 | C5 | 0.3 | | | 22 | 5/6 | 50 |
| 65 | A1 | 1.6 | B2 | 0.5 | C6 | 0.3 | | | 12 | 6/6 | 50 |
| 66 | A1 | 1.6 | B2 | 0.5 | C7 | 0.3 | | | 18 | 5/6 | 50 |
| 67 | A1 | 1.6 | B2 | 0.5 | C8 | 0.3 | | | 14 | 5/6 | 50 |

| | | | | | | | | | | | |
|---|---|---|---|---|---|---|---|---|---|---|---|
| * In Tables 4-1 and 4-2, "Difference in softening point (°C)" means the difference between the softening point of Te-based glass frit and the softening point of Pb-Bi-based glass frit. | | | | | | | | | | | |

Each of these samples was printed on the antireflective film surface of the silicon substrate and then fired at a peak temperature of 805°C in air, to form 100 µm-wide finger electrodes at a 1.6 mm pitch and two 2 mm-wide bus bar electrodes. Accordingly, a solar cell element was obtained.

### [Evaluation of the contact resistance and tensile strength]

Using the transmission line model (TLM) method, the contact resistance was evaluated on each of samples 1 to 67 by measuring the contact resistance value between finger electrodes using a digital multimeter (3458A MULTIMETER from Hewlett-Packard). A contact resistance of equal to or less than 80 mΩcm² was evaluated as satisfying the contact resistance required for a front surface electrode. The contact resistance is preferably equal to or less than 50 mΩcm² and is more preferably equal to or less than 20 mΩcm².

The tensile strength was measured and evaluated by attaching a copper wire to the front surface electrode by soldering and pulling this up in the perpendicular direction. In the case of a low tensile strength, the front surface electrode is peeled off during pull up; in the case of a high tensile strength, the front surface electrode is not peeled off during pull up while the cell undergoes rupture. The measurement was run 6 times on each sample, and an evaluation that the tensile strength satisfies that required for a front surface electrode was rendered when the front surface electrode was not peeled off and the cell underwent rupture in at least 3 of the 6 times (equal to or greater than 3/6). The tensile strength is preferably equal to or greater than 4/6. The results of these contact resistance and tensile strength measurements are given in Tables 4-1 and 4-2.

As may be understood from Tables 4-1 and 4-2, sample 1, which contains only a tellurium-based glass frit as its glass component, has a low contact resistance but a low tensile strength. Sample 3, which contains only a lead-bismuth-based glass frit as its glass component, has a high tensile strength but also a high contact resistance. Sample 2, which contains only a lead-tellurium-based glass frit as its glass component, has properties intermediate between those of samples 1 and 3 for its contact resistance and tensile strength, but both of these properties are inadequate. In addition, sample 4, which contains a tellurium-based glass and a lead-tellurium-based glass as its glass component, has a low contact resistance but a low tensile strength and has properties resembling those for a tellurium-based glass. That is, a low contact resistance cannot co-exist with a high tensile strength in any of these instances.

On the other hand, samples 5 to 67, in which a tellurium-based glass is mixed with a lead-bismuth-based glass as the glass component, in all instances have a low contact resistance and a high tensile strength and thus exhibit excellent outcomes. As may be understood from the measurement results for samples 8 to 16, better results were obtained when the mixed glass frit also contained tin (Sn), tin(II) oxide (SnO), or tin(IV) oxide (SnO₂) as an additive, than were obtained with the additive-free sample 7. In addition, as may be understood from samples 50 to 67, better results were obtained by the additional admixture of a lead-tellurium-based glass along with the tellurium-based glass and lead-bismuth-based glass.

### EXPLANATION OF REFERENCE SIGNS

- 1: semiconductor substrate (silicon substrate)
- 1a: opposite conductivity type layer
- 1b: BSF region
- 1c: microscopic projections
- 2: antireflective film
- 3: first electrode (front surface electrode)
- 4: second electrode (back surface electrode)
- 10: solar cell element

## Claims

1. A conductive paste for a solar cell element front surface electrode that is used to form a front surface electrode of a solar cell element that is provided with a semiconductor substrate, an antireflective film disposed in a first region on one main surface of the semiconductor substrate, and a front surface electrode disposed in a second region on the one main surface of the semiconductor substrate, **characterized in that** the conductive paste comprises a conductive powder, a mixed glass frit, and an organic vehicle in which the mixed glass frit contains, in the form of mixture, a tellurium-based glass frit containing tellurium, tungsten, and bismuth and a lead-bismuth-based glass frit that contains lead and bismuth and that does not contain more than 1,000 ppm tellurium;
wherein the mixed glass frit contains the tellurium-based glass frit and the lead-bismuth-based glass frit at a blending ratio of 4 : 6 to 8 : 2 as a mass ratio;
wherein the tellurium-based glass frit contains, as the oxide, 30 to 80 mol% of tellurium, 10 to 50 mol% of tungsten, and 5 to 25 mol% of bismuth;
wherein the lead-bismuth-based glass frit contains, as the oxide, 30 to 70 mol% of lead, 10 to 40 mol% of bismuth, not more than 30 mol% of zinc (including 0 mol%), and 5 to 30 mol% of silicon or the lead-bismuth-based glass frit contains, as the oxide, 30 to 70 mol% of lead, 10 to 40 mol% of bismuth, not more than 30 mol% of zinc (including 0 mol%), and 1 to 25 mol% of boron;
wherein the content of the mixed glass frit in the conductive paste is 0.1 to 10 mass parts per 100 mass parts of the conductive powder, wherein the tellurium-based glass frit and the lead-bismuth-based glass frit are contained in a total at more than 50 mass parts per 100 mass parts of the overall mixed glass frit; and
wherein the conductive powder contains more than 50 mass% silver.

2. The conductive paste for a solar cell element front surface electrode according to claim 1, wherein a softening point of the tellurium-based glass frit is 10 to 100°C lower than a softening point of the lead-bismuth-based glass frit.

3. The conductive paste for a solar cell element front surface electrode according to claim 1 or 2, wherein the mixed glass frit further contains a lead-tellurium-based glass frit containing, as the oxide, 30 to 70 mol% of lead, 20 to 60 mol% of tellurium, and 5 to 10 mol% of tungsten, wherein the sum of the lead, tellurium, and tungsten is at least 60 mol%..

4. The conductive paste for a solar cell element front surface electrode according to any one of claims 1 to 3, wherein the conductive paste further contains at least one selected from the group consisting of tin, tin(II) oxide, and tin(IV) oxide as an additive.

5. A method for manufacturing a solar cell element which comprises a silicon semiconductor substrate, an antireflective film disposed in a first region on one main surface of the semiconductor substrate, and a front surface electrode disposed in a second region on the one main surface of the semiconductor substrate,
the method comprising:
a first step of forming the antireflective film on the one main surface of the semiconductor substrate;
a second step of printing, on the antireflective film, a conductive paste comprising a conductive powder, a mixed glass frit, and an organic vehicle in which, the mixed glass frit contains, in the form of mixture, a tellurium-based glass frit containing tellurium, tungsten, and bismuth and a lead-bismuth-based glass frit that contains lead and bismuth and that does not contain more than 1,000 ppm tellurium;
and a third step of disposing the antireflective film in the first region of the semiconductor substrate and forming the front surface electrode in the second region of the semiconductor substrate, by firing the conductive paste and removing the antireflective film located under the conductive paste,
wherein the mixed glass frit contains the tellurium-based glass frit and the lead-bismuth-based glass frit at a blending ratio of 4 : 6 to 8 : 2 as a mass ratio;
wherein the tellurium-based glass frit contains, as the oxide, 30 to 80 mol% of tellurium, 10 to 50 mol% of tungsten, and 5 to 25 mol% of bismuth;
wherein the lead-bismuth-based glass frit contains, as the oxide, 30 to 70 mol% of lead, 10 to 40 mol% of bismuth, not more than 30 mol% of zinc (including 0 mol%), and 5 to 30 mol% of silicon or the lead-bismuth-based glass frit contains, as the oxide, 30 to 70 mol% of lead, 10 to 40 mol% of bismuth, not more than 30 mol% of zinc (including 0 mol%), and 1 to 25 mol% of boron;
wherein the content of the mixed glass frit in the conductive paste is 0.1 to 10 mass parts per 100 mass parts of the conductive powder, wherein the tellurium-based glass frit and the lead-bismuth-based glass frit are contained in a total at more than 50 mass parts per 100 mass parts of the overall mixed glass frit; and
wherein the conductive powder contains more than 50 mass% silver.

6. The method for manufacturing a solar cell element according to claim 5, wherein a softening point of the tellurium-based glass frit is 10 to 100°C lower than a softening point of the lead-bismuth-based glass frit.

7. The method for manufacturing a solar cell element according to claim 5 or 6, wherein the mixed glass frit further contains a lead-tellurium-based glass frit containing, as the oxide, 30 to 70 mol% of lead, 20 to 60 mol% of tellurium, and 5 to 10 mol% of tungsten, wherein the sum of the lead, tellurium, and tungsten is at least 60 mol%.

8. The method for manufacturing a solar cell element according to any one of claims 5 to 7, wherein the conductive paste further contains at least one selected from the group consisting of tin, tin(II) oxide, and tin(IV) oxide as an additive.

## Patentansprüche

1. Leitende Paste für eine Solarzellenelementstirnflächenelektrode, die verwendet wird, um eine Stirnflächenelektrode eines Solarzellenelements zu bilden, das mit einem Halbleitersubstrat, einer Antireflexionsschicht, die in einem ersten Bereich auf einer Hauptfläche des Halbleitersubstrats angeordnet ist, und einer Stirnflächenelektrode, die in einem zweiten Bereich auf der Hauptfläche des Halbleitersubstrats angeordnet ist, ausgestattet ist, **dadurch gekennzeichnet, dass** die leitende Paste ein leitendes Pulver, eine gemischte Glasfritte und einen organischen Trägerstoff umfasst, wobei die gemischte Glasfritte in der Form einer Mischung eine auf Tellur basierende Glasfritte, die Tellur, Wolfram und Wismut enthält, und eine auf Blei-Wismut basierende Glasfritte, die Blei und Wismut enthält, und die nicht mehr als 1000 ppm Tellur enthält, enthält;
wobei die gemischte Glasfritte die auf Tellur basierende Glasfritte und die auf Blei-Wismut basierende Glasfritte mit einem Mischungsverhältnis von 4:6 bis 8:2 als einem Massenverhältnis enthält;
wobei die auf Tellur basierende Glasfritte als das Oxid 30 bis 80 Mol-% Tellur, 10 bis 50 Mol-% Wolfram und 5 bis 25 Mol-% Wismut enthält;
wobei die auf Blei-Wismut basierende Glasfritte als das Oxid 30 bis 70 Mol-% Blei, 10 bis 40 Mol-% Wismut, nicht mehr als 30 Mol-% Zink (einschließlich 0 Mol-%) und 5 bis 30 Mol-% Silizium enthält oder die auf Blei-Wismut basierende Glasfritte als das Oxid 30 bis 70 Mol-% Blei, 10 bis 40 Mol-% Wismut, nicht mehr als 30 Mol-% Zink (einschließlich 0 Mol-%) und 1 bis 25 Mol-% Bor enthält;
wobei der Inhalt der gemischten Glasfritte in der leitenden Paste 0,1 bis 10 Masseteile pro 100 Masseteile des leitenden Pulvers beträgt, wobei die auf Tellur basierende Glasfritte und die auf Blei-Wismut basierende Glasfritte insgesamt mit mehr als 50 Masseteilen pro 100 Masseteile der gesamten gemischten Glasfritte enthalten sind; und
wobei das leitende Pulver mehr als 50 Massen-% Silber enthält.

2. Leitende Paste für eine Solarzellenelementstirnflächenelektrode nach Anspruch 1, wobei ein Schmelzpunkt der auf Tellur basierenden Glasfritte 10 bis 100 °C niedriger als ein Schmelzpunkt der auf Blei-Wismut basierenden Glasfritte ist.

3. Leitende Paste für eine Solarzellenelementstirnflächenelektrode nach Anspruch 1 oder 2, wobei die gemischte Glasfritte ferner eine auf Blei-Tellur basierende Glasfritte enthält, die als das Oxid 30 bis 70 Mol-% Blei, 20 bis 60 Mol-% Tellur und 5 bis 10 Mol-% Wolfram enthält, wobei die Summe von Blei, Tellur und Wolfram mindestens 60 Mol-% beträgt.

4. Leitende Paste für eine Solarzellenelementstirnflächenelektrode nach einem der Ansprüche 1 bis 3, wobei die leitende Paste ferner mindestens eines, das aus der Gruppe ausgewählt ist, die aus Zinn, Zinn(II)Oxid und Zinn(IV)Oxid besteht, als einen Zusatzstoff enthält.

5. Verfahren zum Herstellen eines Solarzellenelements, das ein Siliziumhalbleitersubstrat, eine Antireflexionsschicht, die in einem ersten Bereich auf einer Hauptfläche des Halbleitersubstrats angeordnet ist und eine Stirnflächenelektrode, die in einem zweiten Bereich auf der einen Hauptfläche des Halbleitersubstrats angeordnet ist, umfasst,
wobei das Verfahren umfasst:
einen ersten Schritt des Bildens der Antireflexionsschicht auf der einen Hauptfläche des Halbleitersubstrats;
einen zweiten Schritt des Druckens auf der Antireflexionsschicht einer leitenden Paste, die ein leitendes Pulver, eine gemischte Glasfritte und einen organischen Trägerstoff umfasst, wobei die gemischte Glasfritte in der Form einer Mischung eine auf Tellur basierende Glasfritte, die Tellur, Wolfram und Wismut enthält, und eine auf Blei-Wismut basierende Glasfritte, die Blei und Wismut enthält und die nicht mehr als 1000 ppm Tellur enthält, enthält;
und einen dritten Schritt des Anordnens der Antireflexionsschicht in dem ersten Bereich des Halbleitersubstrats und Bilden der Stirnflächenelektrode in dem zweiten Bereich des Halbleitersubstrats durch Anzünden der leitenden Paste und Entfernen der Antireflexionsschicht, die sich unter der leitenden Paste befindet,
wobei die gemischte Glasfritte die auf Tellur basierende Glasfritte und die auf Blei-Wismut basierende Glasfritte mit einem Mischungsverhältnis von 4:6 bis 8:2 als einem Masseverhältnis enthält;
wobei die auf Tellur basierende Glasfritte als das Oxid 30 bis 80 Mol-% Tellur, 10 bis 50 Mol-% Wolfram und 5 bis 25 Mol-% Wismut enthält;
wobei die auf Blei-Wismut basierende Glasfritte als das Oxid 30 bis 70 Mol-% Blei, 10 bis 40 Mol-% Wismut, nicht mehr als 30 Mol-% Zink (einschließlich 0 Mol-%) und 5 bis 30 Mol-% Silizium enthält oder die auf Blei-Wismut basierende Glasfritte als das Oxid 30 bis 70 Mol-% Blei, 10 bis 40 Mol-% Wismut, nicht mehr als 30 Mol-% Zink (einschließlich 0 Mol-%) und 1 bis 25 Mol-% Bor enthält;
wobei der Inhalt der gemischten Glasfritte in der leitenden Paste 0,1 bis 10 Masseteile pro 100 Masseteile des leitenden Pulvers beträgt, wobei die auf Tellur basierende Glasfritte und die auf Blei-Wismut basierende Glasfritte insgesamt mit mehr als 50 Masseteilen pro 100 Masseteile der gesamten gemischten Glasfritte enthalten sind; und
wobei das leitende Pulver mehr als 50 Massen-% Silber enthält.

6. Verfahren zum Herstellen eines Solarzellenelements nach Anspruch 5, wobei ein Schmelzpunkt der auf Tellur basierenden Glasfritte 10 bis 100 °C niedriger als ein Schmelzpunkt der auf Blei-Wismut basierenden Glasfritte ist.

7. Verfahren zum Herstellen eines Solarzellenelements nach Anspruch 5 oder 6, wobei die gemischte Glasfritte ferner eine auf Blei-Tellur basierende Glasfritte enthält, die als das Oxid 30 bis 70 Mol-% Blei, 20 bis 60 Mol-% Tellur und 5 bis 10 Mol-% Wolfram enthält, wobei die Summe von Blei, Tellur und Wolfram mindestens 60 Mol-% beträgt.

8. Verfahren zum Herstellen eines Solarzellenelements nach einem der Ansprüche 5 bis 7, wobei die leitende Paste ferner mindestens eines, das aus der Gruppe ausgewählt ist, die aus Zinn, Zinn(II)Oxid und Zinn(IV)Oxid besteht, als einen Zusatzstoff enthält.

## Revendications

1. Pâte conductrice pour une électrode de surface avant d'un élément de cellule solaire qui est utilisée pour former une électrode de surface avant d'un élément de cellule solaire qui est doté d'un substrat semiconducteur, d'un film antireflet disposé dans une première région sur une surface principale du substrat semiconducteur et une électrode de surface avant disposée dans une deuxième région sur ladite surface principale du substrat semiconducteur, **caractérisée en ce que** la pâte conductrice comprend une poudre conductrice, une frite de verre mixte et un excipient organique dans lequel la frite de verre mixte contient, sous forme de mélange, une frite de verre à base de tellure contenant du tellure, du tungstène et du bismuth et une frite de verre à base de plomb-bismuth qui contient du plomb et du bismuth et qui ne contient pas plus de 1 000 ppm de tellure ;
la frite de verre mixte contenant la frite de verre à base de tellure et la frite de verre à base de plomb-bismuth selon un rapport de mélange de 4/6 à 8/2 comme rapport massique ;
la frite de verre à base de tellure contenant, en tant qu'oxyde, de 30 à 80 % en mole de tellure, de 10 à 50 % en mole de tungstène et de 5 à 25 % en mole de bismuth ;
la frite de verre à base de plomb-bismuth contenant, en tant qu'oxyde, de 30 à 70 % en mole de plomb, de 10 à 40 % en mole de bismuth, pas plus de 30 % en mole de zinc (y compris 0% en mole) et de 5 à 30 % en mole de silicium ou la frite de verre à base de plomb-bismuth contenant, en tant qu'oxyde, de 30 à 70 % en mole de plomb, de 10 à 40 % en mole de bismuth, pas plus de 30 % en mole de zinc (y compris 0 % en mole) et de 1 à 25 % en mole de bore ;
la teneur de la frite de verre mixte dans la pâte conductrice allant de 0,1 à 10 parts en masse pour 100 parts en masse de la poudre conductrice, la frite de verre à base de tellure et la frite de verre à base de plomb-bismuth étant présentes dans une quantité totale à raison de plus de 50 parts en masse pour 100 parts en masse de la frite de verre mixte totale ; et
la poudre conductrice contenant plus de 50 % en masse d'argent.

2. Pâte conductrice pour une électrode de surface avant d'un élément de cellule solaire selon la revendication 1, dans laquelle un point de ramollissement de la frite de verre à base de tellure est de 10 à 100°C inférieur à un point de ramollissement de la frite de verre à base de plomb-bismuth.

3. Pâte conductrice pour une électrode de surface avant d'un élément de cellule solaire selon la revendication 1 ou 2, dans laquelle la frite de verre mixte contient en outre une frite de verre à base de plomb-tellure contenant, en tant qu'oxyde, de 30 à 70 % en mole de plomb, de 20 à 60 % en mole de tellure et de 5 à 10 % en mole de tungstène, la somme des plomb, tellure et tungstène étant au moins de 60 % en mole.

4. Pâte conductrice pour une électrode de surface avant d'un élément de cellule solaire selon l'une quelconque des revendications 1 à 3, la pâte conductrice contenant en outre au moins un élément choisi dans le groupe constitué par l'étain, l'oxyde d'étain (II) et l'oxyde d'étain (IV) en tant qu'adjuvant.

5. Procédé de fabrication d'un élément de cellule solaire qui comprend un substrat semiconducteur de silicium, un film antireflet disposé dans une première région sur une surface principale du substrat semiconducteur et une électrode de surface avant disposée dans une deuxième région sur ladite surface principale du substrat semiconducteur,
le procédé comprenant :
une première étape de formation du film antireflet sur ladite surface principale du substrat semiconducteur ;
une deuxième étape d'impression, sur le film antireflet, d'une pâte conductrice comprenant une poudre conductrice, une frite de verre mixte et un excipient organique dans lesquels la frite de verre contient, sous forme de mélange, une frite de verre à base de tellure contenant du tellure, du tungstène et du bismuth et une frite de verre à base de plomb-bismuth qui contient du plomb et bismuth et qui ne contient pas plus de 1 000 ppm de tellure ;
et une troisième étape consistant à disposer le film antireflet dans la première région du substrat semiconducteur et à former l'électrode de surface avant dans la deuxième région du substrat semiconducteur, par la cuisson de la pâte conductrice et le retrait du film antireflet situé sous la pâte conductrice,
la frite de verre mixte contenant la frite de verre à base de tellure et la frite de verre à base de plomb-bismuth selon un rapport de mélange de 4/6 à 8/2 comme rapport massique ;
la frite de verre à base de tellure contenant, en tant qu'oxyde, de 30 à 80 % en mole de tellure, de 10 à 50 % en mole de tungstène et de 5 à 25 % en mole de bismuth ;
la frite de verre à base de plomb-bismuth contenant, en tant qu'oxyde, de 30 à 70 % en mole de plomb, de 10 à 40 % en mole de bismuth, pas plus de 30 % en mole de zinc (y compris 0% en mole) et de 5 à 30 % en mole de silicium ou la frite de verre à base de plomb-bismuth contenant, en tant qu'oxyde, de 30 à 70 % en mole de plomb, de 10 à 40 % en mole de bismuth, pas plus de 30 % en mole de zinc (y compris 0 % en mole) et de 1 à 25 % en mole de bore ;
la teneur de la frite de verre mixte dans la pâte conductrice allant de 0,1 à 10 parts en masse pour 100 parts en masse de la poudre conductrice, la frite de verre à base de tellure et la frite de verre à base de plomb-bismuth étant présentes dans une quantité totale à raison de plus de 50 parts en masse pour 100 parts en masse de la frite de verre mixte totale ; et
la poudre conductrice contenant plus de 50 % en masse d'argent.

6. Procédé de fabrication d'un élément de cellule solaire selon la revendication 5, dans lequel un point de ramollissement de la frite de verre à base de tellure est de 10 à 100°C inférieur à un point de ramollissement de la frite de verre à base de plomb-bismuth.

7. Procédé de fabrication d'un élément de cellule solaire selon la revendication 5 ou 6, dans lequel la frite de verre mixte contient une frite de verre à base de plomb-tellure contenant, en tant qu'oxyde, de 30 à 70 % en mole de plomb, de 20 à 60 % en mole de tellure et de 5 à 10 % en mole de tungstène, la somme des plomb, tellure et tungstène étant au moins de 60 % en mole.

8. Procédé de fabrication d'un élément de cellule solaire selon l'une quelconque des revendications 5 à 7, dans lequel la pâte conductrice contient en outre au moins un élément choisi dans le groupe constitué par l'étain, l'oxyde d'étain (II) et l'oxyde d'étain (IV) en tant qu'adjuvant.
